Europäisches Patentamt

European Patent Office

Office européen des brevets

(19)

(11) **EP 0 735 696 B1**

(12) **FASCICULE DE BREVET EUROPEEN**

(45) Date de publication et mention
de la délivrance du brevet:
**11.07.2001 Bulletin 2001/28**

(51) Int Cl.⁷: **H03M 13/23**, H03M 13/27,
H03M 13/00

(21) Numéro de dépôt: **96107690.8**

(22) Date de dépôt: **22.04.1992**

(54) **Procédé de décodage itératif, module de décodage et décodeur correspondants**

Iteratives Dekodierungsverfahren, Dekodierungsmodul und Dekoder dafür

Iterative decoding method, decoding module and decoder therefor

(84) Etats contractants désignés:
**DE GB**

(30) Priorité: **23.04.1991 FR 9105280**

(43) Date de publication de la demande:
**02.10.1996 Bulletin 1996/40**

(62) Numéro(s) de document de la (des) demande(s)
initiale(s) en application de l'article 76 CBE:
**92460013.3 / 0 511 141**

(73) Titulaires:
• **FRANCE TELECOM**
  **92131 ISSY LES MOULINEAUX (FR)**
• **TELEDIFFUSION DE FRANCE S.A.**
  **92542 Montrouge Cédex (FR)**

(72) Inventeur: **Berrou, Claude**
**29280 Locmaria Plouzane (FR)**

(74) Mandataire: **Vidon, Patrice**
**Cabinet Patrice Vidon**
**Le Nobel (Bât. A)**
**Technopôle Atalante**
**2, allée Antoine Becquerel**
**BP 90333**
**35703 Rennes Cedex 7 (FR)**

(56) Documents cités:
**EP-A- 0 210 932**          **EP-A- 0 282 298**
**US-A- 4 295 218**

• **NAKANO Y ET AL: "New decoding methods of interleaved burst error correcting codes" TRANSACTIONS OF THE INSTITUTE OF ELECTRONICS AND COMMUNICATION ENGINEERS OF JAPAN, PART A, APRIL 1983, JAPAN, vol. J66A, no. 4, pages 20-28, XP002084518 ISSN 0373-6091**

## Description

Procédé de décodage itératif, module de décodage et décodeur correspondants.

Le domaine de l'invention est celui du codage de données numériques appartenant à une séquence de données source destinée à être transmise, ou diffusée, notamment en présence de bruit de transmission, et du décodage des données codées ainsi transmises.

Plus précisément, l'invention concerne un procédé de décodage, permettant la réalisation de décodeurs modulaires, à plusieurs niveaux de qualité en fonction du nombre de modules mis en oeuvre.

L'invention trouve des applications dans tous les cas où il est nécessaire de transmettre des informations numériques avec un certain degré de fiabilité. Un domaine d'application privilégié de l'invention est celui de la transmission numérique sur des canaux très bruités. A titre d'exemple, l'invention peut être mise en oeuvre pour l'émission et la réception de signaux par l'intermédiaire de satellites. Elle peut également avantageusement être utilisée pour les transmissions spatiales vers, ou entre, des vaisseaux spatiaux et/ou des sondes spatiales, et plus généralement dans tous les cas où la fiabilité du décodage est critique. L'invention peut toutefois s'appliquer de la même façon à tout type de transmission, par voie hertzienne ou par câble.

Tout signal numérique, quel qu'en soit l'origine, peut être codé et décodé selon l'invention. Il peut par exemple s'agir d'un signal d'images, d'un signal sonore, d'un signal de données, ou d'un multiplex de plusieurs signaux distincts.

De façon connue, le codage de tels signaux est en général réalisé à l'aide d'un ou plusieurs codeurs convolutifs. Dans le décodeur, les données d'origine sont le plus souvent reconstruites à l'aide d'un algorithme à maximum de vraisemblance, et par exemple l'algorithme de Viterbi, dont les décisions peuvent éventuellement être pondérées.

Les codes convolutifs sont des codes associant à chaque donnée source à coder au moins une donnée codée, obtenue par sommation modulo 2 de cette donnée source avec au moins une des données source précédentes. Ainsi, chaque symbole codé est une combinaison linéaire de la donnée source à coder et des données source précédentes prises en compte. L'algorithme de Viterbi, en prenant en compte une séquence de symboles codés reçus, fournit une estimation de chaque donnée codée à l'émission, en déterminant la séquence source correspondant le plus probablement à la séquence reçue.

Il est également connu de mettre en série plusieurs codeurs, qu'ils soient convolutifs ou non. Dans ce cas, les données codées par un premier codeur alimentent un second codeur, qui "surcode" ces données. Le décodage se fait évidemment symétriquement, en commençant par le second code.

Ce principe, appelé concaténation de codes, présente deux types d'inconvénients. Tout d'abord, le rendement global des codeurs mettant en oeuvre des codes contaténés est faible. Par exemple, dans le cas de deux codeurs en série ayant chacun un rendement 1/2, le rendement global sera de 1/4. Si l'on utilise plus de deux codeurs, ce rendement devient rapidement très faible.

Par ailleurs, la réalisation technique de ces codeurs est relativement complexe, notamment en ce qui concerne les horloges associées à chaque code, qui doivent être indépendantes.

En ce qui concerne les décodeurs, on a déjà indiqué que l'on mettait généralement en oeuvre des algorithmes à maximum de vraisemblance, tels que l'algorithme de Viterbi. Ces algorithmes prennent des décisions en tenant compte d'un nombre important de symboles reçus. Clairement, la décision est d'autant plus fiable que le nombre de symboles pris en compte est élevé. En revanche, plus ce nombre est élevé, plus le décodeur est complexe. La place mémoire nécessaire devient rapidement très importante, de même que les temps de calcul correspondants.

Les circuits intégrés mettant en oeuvre de tels algorithmes reposent donc le plus souvent sur un compromis entre le coût et les performances. Ces choix industriels ne permettent pas de construire des décodeurs correspondant de façon optimum à une application donnée. Il n'est par exemple pas possible de réaliser des décodeurs à faible prix de revient, pour des applications où la qualité de réception n'est pas cruciale, les circuits intégrés ayant un coût trop élevé. Inversement, ces circuits intégrés ne sont pas non plus adaptés à la réalisation de récepteurs à très haute qualité de décodage, pour lesquels le prix de revient n'a que peu d'importance.

L'invention a notamment pour objectif de pallier ces différents inconvénients et limites de l'état de la technique.

Plus précisément, un objectif de l'invention est de fournir un procédé de codage et un procédé de décodage de données numériques à très bon pouvoir de correction, en comparaison avec les procédés connus utilisés actuellement dans les systèmes de communications numériques.

L'invention a notamment pour objectif de fournir de tels procédés, particulièrement efficaces, toujours par rapport aux procédés connus, pour la transmission dans des canaux très bruités.

Un objectif particulier de l'invention est de fournir de tels procédés autorisant un décodage très fiable des données reçues, et par exemple de données transmises par satellites, ou issues de sondes ou de vaisseaux spatiaux.

L'invention a encore pour objectif de fournir de tels procédés, permettant de coder et de décoder des données à des débits très élevés.

L'invention a également pour objectif de fournir de tels procédés, permettant une réalisation des codeurs et des décodeurs relativement aisée, en regard de leurs performances.

Notamment, l'invention a pour objectif de fournir un procédé de codage mettant en oeuvre plusieurs codes convolutifs, mais ne nécessitant, tant au codeur qu'au décodeur, qu'une seule horloge.

Un autre objectif de l'invention est de fournir un tel procédé de codage, ayant un très bon rendement global de codage.

L'invention a encore pour objectif de fournir des procédés de codage et de décodage, permettant la réalisation de décodeurs très performants, mais malgré tout aisément réalisables industriellement à des coûts acceptables.

Ainsi, un objectif particulier de l'invention est de fournir de tels procédés, permettant l'implantation du procédé de décodage sur une surface de silicium suffisamment restreinte pour que son industrialisation soit possible, et par exemple sur une surface inférieure à 50 mm$^2$.

L'invention a également pour objectif de fournir de tels procédés de codage et de décodage permettant la réalisation de nombreux types de décodeurs, à performances et prix de revient variables en fonction des besoins auxquels ils répondent, et mettant en oeuvre un ou plusieurs circuits intégrés d'un type unique.

En d'autres termes, un objectif essentiel de l'invention est de fournir de tels procédés permettant d'une part une industrialisation rentable, basée sur le développement d'un circuit intégré unique et relativement simple, et d'autre part la réalisation de décodeurs utilisables pour une très grande diversité d'applications.

Ces objectifs, ainsi que d'autres qui apparaîtront par la suite, sont atteints selon l'invention à l'aide d'un procédé de décodage de données numériques reçues sous forme codée et correspondant à des données source, comprenant une procédure de décodage itérative comprenant :

- une étape de décodage d'une donnée intermédiaire représentative d'une donnée reçue, produisant une donnée décodée, et
- une étape d'estimation de ladite donnée reçue, à l'aide de ladite donnée décodée, produisant une donnée estimée, ladite donnée intermédiaire étant obtenue, pour la première itération, par une combinaison de ladite donnée reçue avec une valeur prédéterminée, et pour les itérations suivantes, par une combinaison de ladite donnée reçue avec au moins une desdites données estimées lors des itérations précédentes.

Ce procédé permet de réaliser des décodeurs constitués d'une cascade de modules identiques, chaque module correspondant à une itération. Il est clair que l'efficacité du décodage est directement fonction du nombre d'itérations pratiquées, et donc du nombre de modules mis en oeuvre. Il est ainsi possible de définir plusieurs niveaux de qualités de récepteurs, simplement en faisant varier le nombre de modules.

Chaque module a donc pour tâche de calculer, outre la donnée décodée, une nouvelle estimation de la donnée émise. Cette grandeur est exploitée dès le module suivant.

Avantageusement, ladite étape d'estimation affecte ladite donnée estimée d'un bruit additif décorrélé du bruit affecté à ladite donnée reçue.

Ainsi, la donnée prise en compte lors de l'itération suivante, combinaison de la donnée reçue et de la donnée estimée, est affectée d'un bruit global moins perturbateur qu'à l'itération précédente.

Dans un mode de réalisation préférentiel de l'invention, ladite valeur prédéterminée est neutre, ou nulle, et lesdites combinaisons sont, pour les itérations autre que la première, des sommations de ladite donnée reçue et de la dernière donnée estimée.

Dans le cas d'un décodage de données codées selon un procédé assurant la transmission conjointe des données source et de données de redondance codées, par exemple à l'aide des codes "pseudo-systématiques" déjà cités, il est avantageux que ladite étape de décodage prenne en compte l'ensemble des données reçues, données source et données codées, mais que ladite étape d'estimation soit appliquée uniquement à l'estimation desdites données source.

Le procédé de décodage de l'invention est avantageusement associé à un procédé de codage correcteur d'erreurs de données numériques source, mettant en oeuvre en parallèle au moins deux étapes indépendantes de codage convolutif systématique, chacune desdites étapes de codage prenant en compte l'ensemble desdites données source, le procédé comprenant au moins une étape d'entrelacement temporel desdites données source, modifiant l'ordre de prise en compte desdites données source pour chacune desdites étapes de codage.

Ce procédé, appelé par la suite codage à "concaténation parallèle", par opposition à la technique classique de "concaténation série" décrite en préambule, permet de disposer, lors du décodage de symboles issus de deux codeurs distincts.

Les codages redondants utilisés sont de type systématique. Chaque donnée source est donc aussi un symbole de codage convolutif, et ce symbole est partagé par les deux codes.

Le partage de la redondance de codage en plusieurs redondances parallèles permet ainsi d'augmenter artificiellement le rendement global du code. Par exemple, un code à "concaténation parallèle" de rendement 1/3 peut en réalité contenir deux codes de rendement 1/2. S'il s'était agi de concaténer, d'un manière classique, c'est-à-dire par une "concaténation série", deux codes de rendement 1/2, le rendement global aurait été de 1/4.

Un autre avantage des codes à "concaténation parallèle", vis-à-vis des codes "à concaténation série", est la simplicité des circuits de codage et de décodage, relativement aux horloges.

Dans un mode de réalisation préférentiel, le procédé de codage comprend une étape d'élimination systématique, à des instants de transmission prédéterminés, d'au moins une donnée codée produite par au moins une desdites étapes de codage.

L'étape d'élimination peut par exemple consister en une commutation périodique entre lesdites étapes de codage, assurant, à chaque instant de transmission, la sélection d'un unique symbole codé parmi l'ensemble des symboles codés par chacune desdites étapes de codage.

De cette façon, un seul symbole codé est transmis à chaque instant de transmission : il n'y a pas d'augmentation du débit global de données. En revanche, le procédé de codage de l'invention assure la transmission systématique de la donnée source à chaque instant de transmission.

Dans ce mode de réalisation, on utilise des codes dits "pseudo-systématiques", tels que ceux décrits dans la demande de brevet française FR 91 05278 intitulée "procédé de codage convolutif correcteur d'erreurs pseudo-systématique, procédé de décodage et dispositifs correspondants", et déposée le 23 avril 1991 aux noms des mêmes déposants. Ces codes permettent d'obtenir de très bonnes qualités de décodage, en particulier en présence d'un bruit de transmission élevé. Ils s'avèrent par ailleurs très intéressants par leur caractéristique systématique pour la mise en oeuvre du procédé de décodage décrit plus loin.

De façon avantageuse, chacune desdites étapes d'entrelacement temporel est suivie d'une étape de retard, ladite étape d'entrelacement temporel prenant en compte les données source dans l'ordre dans lequel lesdites données source alimentent une première étape de codage, et les restituant dans un ordre différent pour alimenter une seconde étape de codage, ladite étape de retard affectant chacune desdites données source issues de ladite étape d'entrelacement temporel d'un retard égal à la latence de décodage de données codées par ladite première étape de codage.

Ces retards s'avèrent utiles pour la mise en oeuvre d'un mode de réalisation du procédé de décodage de l'invention, ainsi qu'on le verra par la suite.

Avantageusement, ladite étape d'entrelacement temporel met en oeuvre au moins une matrice d'entrelacement dans laquelle lesdites données source sont inscrites par lignes (respectivement colonnes) successives et lues par colonnes (respectivement lignes) successives.

Cette étape d'entrelacement permet que toutes les données source soient prises en compte et codées, mais suivant des séquences différentes pour les deux codes. L'entrelacement peut donc être fait de façon classique, à l'aide d'une matrice d'entrelacement. Toutefois, l'invention propose plusieurs adaptations possibles de cette technique, ayant pour but d'améliorer l'efficacité de l'entrelacement.

Ainsi, de façon préférentielle, à l'écriture, l'incrément entre deux lignes (respectivement colonnes) et/ou, à la lecture, l'incrément entre deux colonnes (respectivement lignes) sont strictement supérieurs à 1.

Par nécessité, ces incréments sont bien sûr également premiers avec le nombre de colonnes ou de lignes de cette matrice.

Avantageusement, à l'écriture (respectivement lecture), ledit incrément entre deux lignes (respectivement colonnes) est fonction de l'emplacement de la colonne (respectivement ligne) en cours d'écriture (respectivement lecture).

Cette technique a pour effet favorable, lors du décodage, de "casser" les paquets d'erreurs à disposition rectangulaire, vis à vis desquels le procédé de décodage est plus vulnérable. Cette technique d'entrelacement sera dite par la suite "à dispersion".

Dans le cas où un tel procédé de codage est mis en oeuvre, le procédé de décodage comprend avantageusement les étapes consécutives suivantes :

- premier décodage selon ledit premier codage redondant, en fonction d'au moins une desdites données intermédiaires et d'au moins une donnée codée produite par ladite première étape de codage, produisant une première donnée décodée,
- entrelacement temporel identique à ladite étape d'entrelacement du procédé de codage desdites premières données décodées,
- second décodage selon ledit second codage redondant, en fonction d'au moins une desdites premières données décodées et désentrelacées et d'au moins une donnée codée produite par ladite seconde étape de codage, produisant une seconde donnée décodée,
- estimation de la donnée source reçue, en fonction de l'une au moins desdites première et seconde données décodées, produisant une donnée estimée,
- désentrelacement symétrique à ladite étape d'entrelacement desdites données estimées.

Avantageusement, ladite étape d'estimation consiste à déterminer la grandeur $(d_2 \times (X_1) - (X_2))/(d_2 - 1)$, où

- $d_2$ est la distance libre dudit second codage redondant ;
- $X_1$ et $X_2$ sont les données décodées par lesdites première et seconde étapes de décodage ;
- désentrelacement (52) symétrique à ladite étape (47) d'entrelacement desdites données estimées $((Z)_p)$.

Cette fonction ôte au résultat de la donnée décodée délivrée par la seconde étape de décodage la contribution liée à la donnée source. Ainsi, les bruits additifs de la donnée source et de la donnée estimée sont pratiquement complètement décorrélés.

De façon préférentielle, ladite étape d'estimation est suivie, avant ladite étape de désentrelacement, d'une étape de compression logarithmique.

Cette compression logarithmique a pour but de mettre l'accent, en terme de précision d'échantillonnage, sur les valeurs critiques, c'est-à-dire sur les valeurs proches de zéro, lorsque les valeurs sont codées entre -n et +n.

Dans un mode de réalisation avantageux de l'invention, ladite première étape de décodage est suivie d'une étape de multiplication de ladite première donnée décodée par un coefficient $\beta$ strictement supérieur à 1.

Ce coefficient $\beta$ a pour rôle de privilégier, pour le deuxième décodage, les valeurs issues du premier décodeur, relativement aux valeurs codées reçues, affectées d'un bruit plus important car directement fournies par le canal de transmission.

Préférentiellement, ledit coefficient $\beta$ est variable en fonction du rapport signal à bruit du canal de transmission.

De façon avantageuse, la ou lesdites étapes de décodage mettent en oeuvre des algorithmes de décodage à maximum de vraisemblance, du type de l'algorithme de Viterbi, à décisions pondérées.

On peut notamment faire appel au procédé de décodage décrit dans la demande conjointe intitulée "procédé de décodage d'un code convolutif à maximum de vraisemblance et pondérations des décisions, et décodeur correspondant", déposée aux noms des mêmes déposants.

Avantageusement, le procédé de décodage comprend également une étape de démultiplexage dirigeant les données codées reçues vers lesdites étapes de décodage adéquates et transmettant des valeurs nulles aux étapes de décodage pour lesquelles aucune donnée codée n'a été transmise.

Cette étape est utile lorsque des données codées sont sélectivement non-émises, à certains instants de transmission.

L'invention concerne également un module de décodage, réalisant une itération de la procédure de décodage décrite ci-dessus. Un tel module comprend au moins deux entrées, correspondant à au moins une donnée reçue et à au moins une donnée estimée, et au moins deux sorties, correspondant à au moins une donnée décodée et au moins une donnée estimée. Il est susceptible d'être cascadé avec au moins un autre module identique.

Un module peut notamment être réalisé sous forme de circuit intégré. Un tel circuit occupe suffisamment peu de surface silicium pour permettre une industrialisation aisée, fiable et peu coûteuse.

La modularité permet de prévoir, à partir d'un unique circuit intégré, tout type d'application. Dans les cas ne nécessitant qu'une faible protection, ou lorsque le canal est peu bruité, un seul module peut suffire. En revanche, dans des cas particuliers où la fiabilité est essentielle et/ou le bruit de transmission est important, par exemple dans le cas de données transmises par une sonde intersidérale, dix modules ou plus pourront être cascadés.

L'invention concerne également les décodeurs mettant en oeuvre un ou plusieurs de ces modules.

D'autres caractéristiques et avantages de l'invention apparaîtront à la lecture de la description suivante d'un mode de réalisation préférentiel de l'invention donné à titre illustratif et non limitatif, et des dessins annexés, dans lesquels :

- la figure 1 est un schéma synoptique illustrant le principe de base du procédé de codage de l'invention, dit "à concaténation parallèle" ;
- la figure 2 présente un mode de réalisation particulier d'un codeur selon le procédé illustré en figure 1, assurant une redondance de 100 % ;
- la figure 3 est un schéma synoptique du principe de base d'un décodeur modulaire selon l'invention, à quatre modules ;
- la figure 4 est un schéma synoptique détaillé d'un mode de réalisation préférentiel d'un module de la figure 3, dans le cas où les données sont codées à l'aide du codeur de la figure 2 ;
- les figures 5 et 6 présentent les résultats obtenus à l'aide d'un décodeur utilisant les modules de la figure 4, en fonction du nombre de modules cascadés, dans le cas d'un décodeur idéal (figure 5) et d'un décodeur implantable sur circuit intégré (figure 6) ;
- la figure 7 présente un exemple de module de codage "pseudo-systématique" ayant une longueur de contrainte $\nu = 2$ et un rendement R = 1/2 pouvant être utilisé dans le codeur de la figure 1.

La présente invention repose sur deux concepts nouveaux, à savoir un procédé de codage mettant en oeuvre simultanément plusieurs codages, en parallèle, et un procédé de décodage itératif.

Prises en combinaison, ces deux caractéristiques présentent une très forte synergie, permettant d'obtenir au décodage un taux d'erreur particulièrement faible, et notamment très inférieur à ceux obtenus avec les décodeurs connus de complexité équivalente, en particulier en présence d'un bruit de transmission élevé.

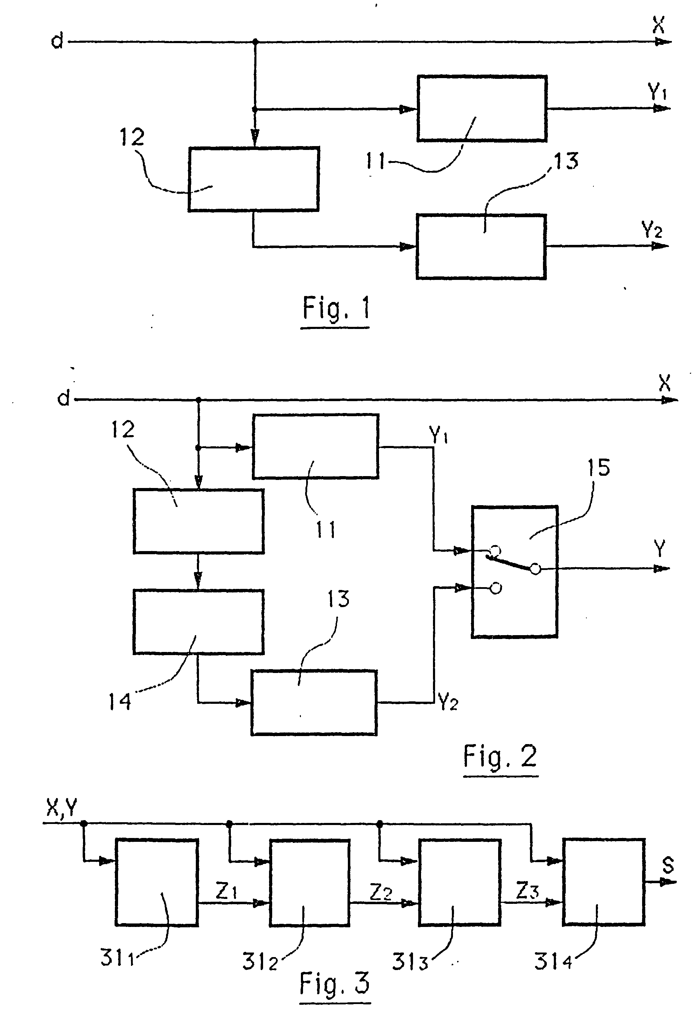

La figure 1 présente un schéma synoptique d'un codeur mettant en oeuvre le procédé de l'invention, dans le cas où deux codes distincts sont utilisés en parallèle.

Chaque donnée source d à coder est dirigée d'une part vers un premier module 11 de codage, et d'autre part vers un module 12 d'entrelacement temporel, qui alimente lui-même un second module 13 de codage.

Selon ce procédé, il apparaît donc qu'il est associé à chaque donnée source d au moins deux données codées $Y_1$ et $Y_2$ issues de codeurs 11 et 13 distincts. Il est clair que le nombre de codeurs, ici limité à deux, peut aisément être étendu selon le même principe.

Les modules 11 et 13 peuvent être de tout type systématique connu. Il s'agit avantageusement de codeurs convolutifs prenant en compte au moins une des données source précédentes pour le codage de la donnée source d. Les codes mis en oeuvre dans ces modules 11 et 13 peuvent être identiques ou, préférentiellement, différents.

Une caractéristique essentielle de l'invention est que les données codées $Y_1$ et $Y_2$ tiennent en compte des mêmes données source d, mais considérées suivant des séquences différentes, grâce à la technique de l'entrelacement. Cet entrelacement peut être obtenu, de façon classique, à l'aide d'une matrice d'entrelacement, dans laquelle les données source sont introduites lignes par lignes, et restituées colonnes par colonnes. Ainsi qu'on le verra plus loin, l'invention propose toutefois des améliorations nouvelles de ce procédé d'entrelacement, destinées notamment à bien séparer les erreurs, au décodage.

Par ailleurs, toute autre technique permettant de modifier l'ordre des données source peut être utilisée dans ce module 12 d'entrelacement temporel.

Dans le mode de réalisation représenté en figure 1, une donnée X, égale à la donnée source d, est systématiquement transmise. Il s'agit d'une caractéristique nécessaire pour la réalisation des modules de décodage tels que décrits plus loin.

Dans ce cas, les modules 11 et 13 de codage utilisent préférentiellement des codes tels que ceux décrits dans la demande de brevet FR 91 05278 déjà citée. Ces codes, dits "pseudo-systématiques", sont caractérisés par le fait que la donnée source est systématiquement transmise, conjointement à au moins une donnée codée, ou symbole de redondance.

Ces symboles de redondance sont construits de façon que la distance libre du code soit maximale. Ils ne tiennent pas compte, ainsi que cela est fait usuellement dans les codes convolutifs, d'une série des données source précédentes, mais d'une série de données auxiliaires, obtenues par combinaison mathématique de la donnée source considérée avec l'une au moins des données auxiliaires précédentes.

Ces codes nouveaux permettent d'obtenir de très bonnes performances, en terme de taux d'erreurs.

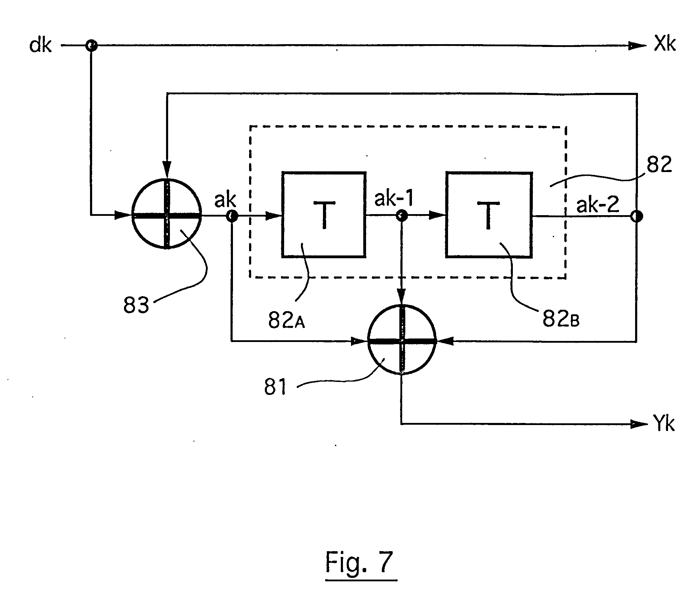

Un exemple de codeur (ayant une longueur de contrainte $\nu = 2$ et un rendement R = 1/2) mettant en oeuvre cette technique est illustré en figure 7.

Ce codeur associe à chaque donnée source $d_k$ deux valeurs codées $X_k$ et $Y_k$.

La donnée $X_k$ est systématiquement prise égale à la valeur source $d_k$.

La donnée $Y_k$ est calculée, de façon classique, à l'aide d'une combinaison 81 d'au moins deux éléments binaires contenus dans un registre à décalage 82. En revanche, ce registre 82 ne contient pas, dans ces cellules $82_A$ et $82_B$, les valeurs source précédentes $d_{k-1}$, $d_{k-2}$, mais des valeurs intermédiaires distinctes $a_{k-1}$, $a_{k-2}$.

La caractéristique essentielle de l'invention est en effet de déterminer la valeur codée de $Y_k$ à partie de valeurs particulières $a_k$ obtenues par une combinaison mathématique, et par exemple un OU exclusif 83, de la donnée source $d_k$ avec l'une au moins des valeurs intermédiaires précédentes $a_{k-2}$ (au contraire des procédés de codage convolutif connus qui prennent en compte directement la série des valeurs source précédentes.

Cela revient, en quelque sorte, à effectuer une contre-réaction sur les valeurs sources $d_k$. Il apparaît que cette contre-réaction permet d'obtenir des performances supérieures à celles des codeurs classiques, tout en ne nécessitant que l'ajout d'un OU exclusif 83 à ces codeurs.

Il semble que ce gain puisse notamment être attribué au fait que les emplacements des erreurs de transmission dans une séquence de données reçues ne sont que rarement complètement décorrélées. L'application d'une combinaison par OU exclusif sur ces données peut alors entraîner l'annulation de certaines de ces erreurs.

De nombreuses simulations avec des codes de longueurs de contraintes et/ou de rendements différents ont permis de constater que dans tous les cas de figures, ce procédé de codage "pseudo-systématique" présente des performances supérieures aux codeurs convolutifs classiques équivalents (en terme de rendement et de longueur de contrainte) notamment lorsque le signal reçu est très bruité ($E_b/N_o$ inférieur ou égal à 3 dB).

Le principe du codage à "concaténation parallèle" selon l'invention présente notamment deux avantages, par rapport au codage classique à concaténation série, ainsi qu'on l'a déjà mentionné : d'une part le rendement global du code est meilleur, et, d'autre part, les circuits de codage et de décodage sont plus simples, en ce qui concerne leurs horloges. En effet, dans le cas de la "concaténation parallèle", tous les circuits fonctionnent à une seule et même horloge : celle du débit des données.

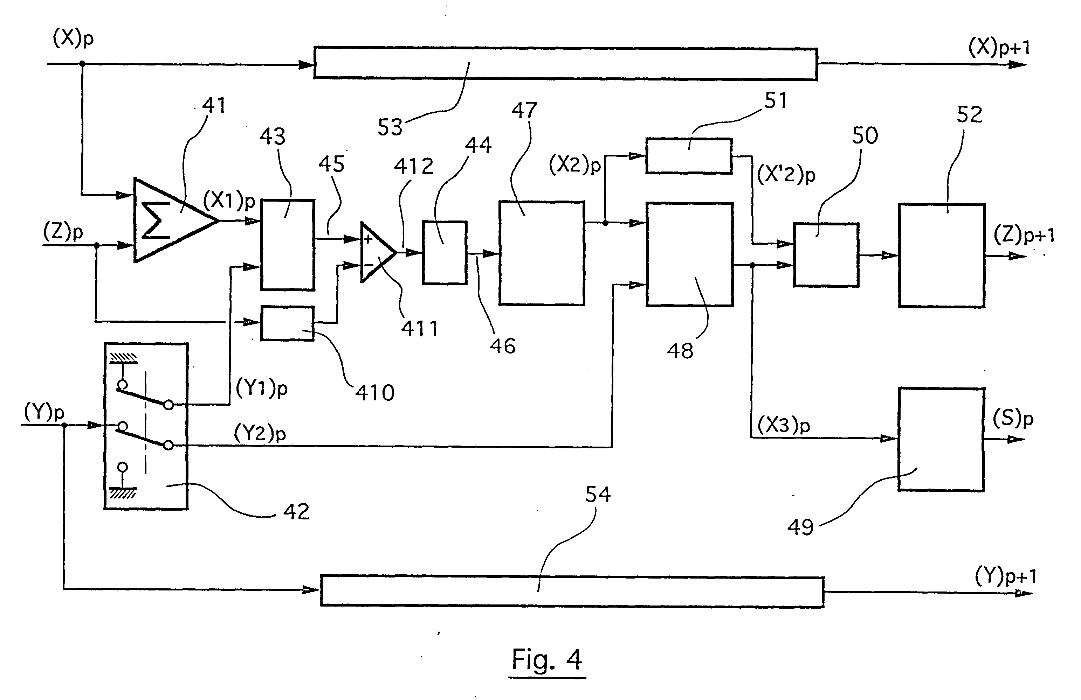

La figure 2 illustre un mode de réalisation particulier d'un tel codeur, plus précisément destiné au codage de données décodables à l'aide des modules décrits plus loin, en relation avec la figure 4.

On considère, à titre d'exemple, un codeur de rendement global R supérieur ou égal à 1/3 (une valeur typique de R est 1/2) mettant en oeuvre deux codes de rendements élémentaires respectifs $R_1$ et $R_2 = (RR_1)/(RR_1 + R_1 - R)$, $R_1$ et $R_2$ étant tous deux supérieurs à 1/2.

Ce codeur émet, à chaque instant de transmission, deux symboles numériques, par exemple binaires, X et Y. Le symbole X est pris systématiquement égal à la donnée source d, et le symbole Y est un symbole de redondance.

Ce symbole Y est égal soit à la valeur $Y_1$ issue du premier module 11 de codage, soit à la valeur $Y_2$ issue du second module 13 de codage. Un module 15 de sélection effectue une commutation périodique entre les sorties $Y_1$ et $Y_2$. La périodicité de la commutation est fixée par les deux rendements $R_1$ et $R_2$, de telle sorte que les symboles X et Y contiennent effectivement deux codes de rendement $R_1$ et $R_2$.

A titre d'exemple, pour des rendements de code $R_1 = 3/5$ et $R_2 = 3/4$, les séquences de données transmises peuvent être :

| $X_t$ | $X_{t+1}$ | $X_{t+2}$ | $X_{t+3}$ | $X_{t+4}$ | $X_{t+5}$, ... |
|-------|-----------|-----------|-----------|-----------|----------------|
| $Y_{1,t}$ | $Y_{1,t+1}$ | $Y_{2,t+2}$ | $Y_{1,t+3}$ | $Y_{1,t+4}$ | $Y_{2,t+5}$, ... |

Le fonctionnement de ce module 15 de sélection peut bien sûr être généralisé. Ainsi, dans le cas où il y a plus de deux modules de codage, la sélection peut se faire de façon à assurer la transmission d'un nombre m de données codées, sélectionnées parmi les n données codées produites. Par ailleurs, ce module 15 de sélection peut également assurer un poinçonnage des données codées, la (ou les) donnée Y n'étant pas transmise à des instants de transmission prédéterminés.

Les données source d sont appliquées au premier module de codage 11 et au module 12 d'entrelacement. Ce module 12 assure un entrelacement matriciel. Les données sont écrites, par lignes successives, dans une mémoire de taille $n_E \times n_E$, et restituées par colonnes successives. Cette technique est par exemple décrite dans l'article "Optimal interleaving scheme for convolutional coding" (Méthode d'entrelacement optimal pour le codage convolutif), de Dunscombe E. et Piper F.C., paru dans l'"Electronic Letters", Vol.25, n°22, Octobre 1989.

Ainsi que le montre cet article, l'efficacité de l'entrelacement, pour de petites valeurs de $n_E$ (quelques dizaines), est améliorée si la succession de lignes et de colonnes s'effectue selon un incrément supérieur à 1 et, par nécessité, premier avec $n_E$.

L'invention propose une nouvelle amélioration à cette technique d'entrelacement. Il apparaît en effet avantageux que l'incrément de saut de ligne, toujours premier avec $n_E$, soit fonction de la place de la colonne considérée. Cela permet de casser les paquets d'erreurs à disposition rectangulaire.

D'autres techniques d'entrelacement peuvent bien sûr être utilisées, et notamment l'habituel procédé à incréments d'écriture et de lecture égaux à 1, sans sortir du cadre de l'invention. Il est clair par ailleurs que les rôles des lignes et des colonnes peuvent être inversés.

Les données issues du module 12 d'entrelacement sont ensuite retardées d'une durée fixée, de façon à compenser la latence $L_1$ du module de décodage correspondant au premier code 11. Pour cela, des moyens 14 de retard, tel qu'un registre à décalage de longueur $L_1$, tenant lieu de ligne à retard, sont disposés en sortie du module 12 d'entrelacement.

On présente maintenant le procédé de décodage selon l'invention, en liaison avec la figure 3.

Ce procédé de décodage a comme caractéristique essentielle d'être itératif. A chaque itération, le décodage d'au moins une donnée intermédiaire est effectué. A l'aide notamment de la donnée décodée, on détermine ensuite une estimation de la donnée à décoder. Lors de l'itération suivante, un décodage identique est effectué, sur une donnée intermédiaire obtenue par combinaison de la donnée reçue avec la donnée estimée. Si le procédé de codage et le procédé d'estimation sont bien choisis, il apparaît, ainsi qu'on le verra par la suite, que la qualité du décodage est fonction du nombre d'itérations effectuées.

L'avantage essentiel de ce procédé itératif est qu'il permet la réalisation de décodeurs modulaires. On peut en effet définir des modules $31_1$ à $31_4$ de décodage, tel que cela est illustré en figure 3. Chaque module effectue une itération du procédé de décodage. En cascadant n modules, on réalise donc n itérations du procédé.

Le module $31_i$ a au moins deux entrées : la donnée X reçue, à décoder, et une donnée $Z_p$ représentative de cette donnée X reçue, estimée par le module précédent $31_{p-1}$, et deux sorties : la donnée $Z_p$ estimée, et la valeur décodée S, prise en compte uniquement en sortie du dernier module. Pour le premier module $31_1$, la donnée $Z_1$ est fixée à une valeur prédéterminée nulle. Avantageusement, la donnée $Z_p$ est déterminée de façon à être représentative du symbole émis X, tout en étant affectée d'un bruit additif décorrélé de celui affecté à la donnée reçue X. Ainsi, au fur et à mesure des itérations, l'influence du bruit est de plus en plus faible, et le taux d'erreur est donc de plus en plus réduit.

Dans d'autres modes de réalisation chaque module peut prendre en compte plusieurs données $Z_p$ estimées lors des étapes précédentes, voire l'ensemble de ces données. La combinaison avec la donnée X recue peut être une simple sommation, ou une sommation pondérée. Il est par exemple envisageable de donner un poids variable aux différentes valeurs $Z_p$ estimées. Il est également possible que ces poids varient en fonction de certains critères, tels que le rapport signal à bruit.

La structure modulaire de l'invention présente notamment deux avantages. Tout d'abord, cela permet de définir plusieurs qualités de décodeurs, à partir d'une même base, simplement en faisant varier le nombre de modules. Cela rend également possible d'augmenter aisément l'efficacité d'un décodeur existant, en ajoutant un ou plusieurs modules, si le besoin s'en fait sentir.

Les différents modules travaillent selon la technique dite "en pipe-line". Chaque module fonctionne en permanence, sur des données différentes. L'ajout d'un module ne perturbe pas le fonctionnement de ses précédécesseurs. Il ne fait que rallonger légèrement le temps global de décodage, de la durée nécessaire à ses propres opérations.

Par ailleurs, cette structure ne nécessite que la conception et l'industrialisation d'un seul module de décodage, par exemple sous forme d'un circuit intégré relativement simple et ne nécessitant pas une surface de silicium trop importante. Son coût n'est donc pas prohibitif, d'autant plus qu'il est susceptible d'être utilisé pour une très large palette d'applications. Selon les besoins, c'est le nombre des modules qui sera variable, et non plus la structure des modules.

Il est à noter que la conception itérative du procédé de l'invention n'empêche aucunement la réalisation de décodeurs plus conventionnels, n'utilisant qu'un unique module. En effet, chaque module possède une entrée donnée reçue et une sortie donnée S décodée.

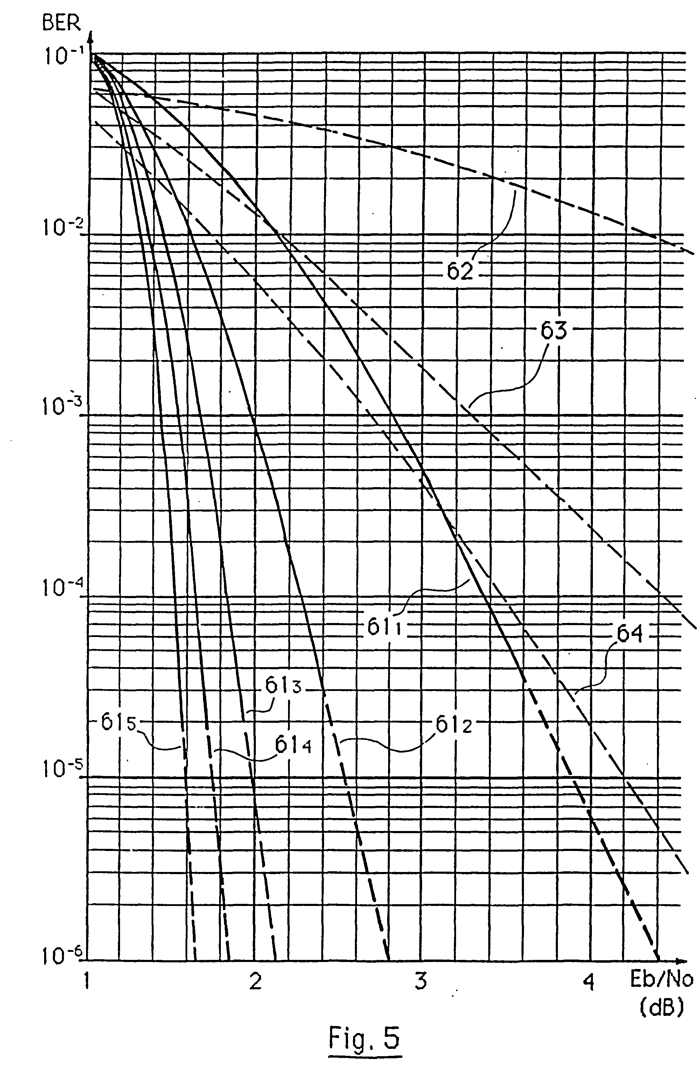

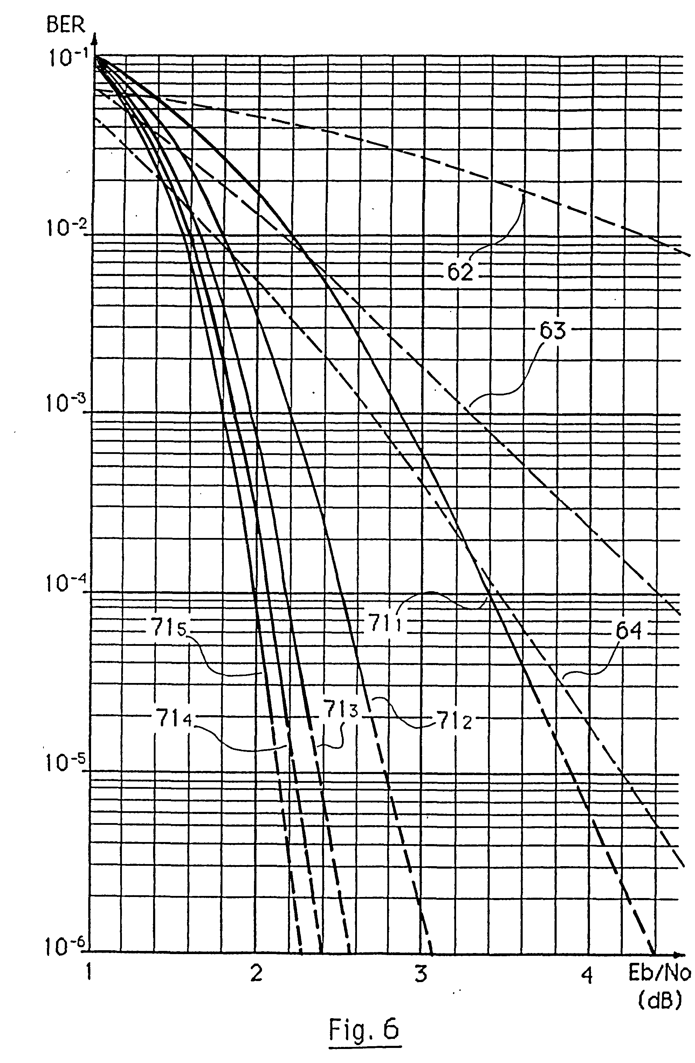

La figure 4 présente un mode de réalisation particulier d'un module selon l'invention, dont les performances sont très intéressantes, ainsi que le font apparaître les courbes des figures 5 et 6, commentées plus loin.

Ce module est destiné au décodage de données codées et transmises à l'aide du codeur de la figure 2.

Un tel module de rang p possède donc :

- 3 entrées : $(X)_p$, $(Y)_p$ et $(Z)_p$,
- 4 sorties : $(X)_{p+1}$, $(Y)_{p+1}$, $(Z)_{p+1}$ et $(S)_p$.

Les grandeurs (X), (Y) et (Z) sont idéalement des variables réelles, et en pratique des échantillons codés sur n bits (typiquement n=4). La grandeur (S), qui représente la sortie du module, est binaire. La décision du décodeur complet est donnée par la sortie (S) du dernier module. Pour ce qui concerne le premier module, les grandeurs d'entrée $(X)_1$ et $(Y)_1$ sont fournies par les symboles correspondants du codeur, après transmission et démodulation. Son entrée $(Z)_1$ est mise à une valeur neutre (poids nul).

Dans ce module, les données en entrée $(X)_p$ et $(Z)_p$ sont additionnées par un sommateur 41 pour fournir la donnée intermédiaire $(X_1)_p$, qui va être utilisée pour le décodage en lieu et place de la donnée reçue $(X)_p$. Ainsi qu'on l'a déjà souligné, les données $(X)_p$ et $(Z)_p$ peuvent éventuellement être pondérées.

La donnée $(Y)_p$ est transmise à des moyens 42 de démultiplexage et d'insertion, dont le rôle est de séparer la redondance $(Y_1)$ produite par le codeur 11 (figure 2) et la redondance $(Y_2)$ produite par le codeur 13, et d'insérer à la place des valeurs (Y) non disponibles des valeurs neutres, de poids nul.

Les données $(X_1)_p$ et $(Y_1)_p$ sont transmises à un premier décodeur 43, réalisant le décodage correspondant au codeur 11. Ce décodeur 43 est construit de telle manière que l'échelle sur son entrée $(X_1)$ soit double de celle de son entrée $(Y_1)$, de façon à tenir compte du fait que $(X_1)$ représente la sommation des deux valeurs (X) et (Z).

La sortie 45 du décodeur 43 est transmise à un soustracteur 411 qui effectue la différence 412 entre cette sortie 45 et l'entrée (Z) considérée à un instant homogène, grâce au registre à décalage 410. (Z) étant une information produite et utilisée par le deuxième décodeur 48 (décrit par la suite) du module précédent, dans le cas d'un décodeur à au moins deux modules de décodage, il est en effet préférable de ne pas la réappliquer lors d'itérations ultérieures.

La différence 412 est ensuite transmise à un multiplieur 44, qui multiplie cette valeur 412 par un facteur $\beta$ supérieur à 1. La multiplication par $\beta$ permet de privilégier, en vue du second décodage, les données issues du premier décodeur 43, relativement aux données $(Y_2)_p$, affectées d'un bruit plus important, puisque directement issues du canal de transmission.

Le facteur $\beta$ peut être fixe. Toutefois, il est avantageusement variable, et dépendant du rapport signal à bruit du canal de transmission. Il est clair par ailleurs que ce multiplieur n'est pas obligatoire pour la mise en oeuvre de l'invention. Il permet cependant d'améliorer sensiblement les performances.

Les données 46 multipliées par $\beta$ sont ensuite entrelacées, à l'aide d'une matrice 47 de taille $n_E$ x $n_E$ similaire à celle utilisée lors du codage. Cette matrice 47 fournit en sortie la valeur $(X_2)_p$ qui est dirigé vers un second décodeur 48, qui prend également en compte les données $(Y_2)_p$ fournit par les moyens 42 de démultiplexage et d'insertion. Ce second décodeur 48 réalise le décodage correspondant au second codeur 13 de la figure 2. Il est construit de telle sorte que l'échelle sur son entrée $(X_2)$ soit $\beta$ fois plus grande que celle de son entrée $(Y_2)$.

Il est à noter que si le codage a lieu en parallèle, le décodage a lieu en série. Ainsi, le second décodeur 48 ne tient pas compte de la donnée reçue $(X)_p$, mais de la donnée décodée, et bien sûr entrelacée, $(X_2)_p$, qui est beaucoup plus fiable. C'est d'ailleurs pour cette raison que cette donnée voit son importance renforcée, par le multiplieur 44.

Avantageusement, les deux décodeurs 43 et 48 mettent en oeuvre un procédé de décodage à maximum de vraisemblance, du type de ceux utilisant l'algorithme de Viterbi, à décisions pondérées.

Dans un mode de réalisation préférentiel, on utilise des décodeurs tels que décrits dans la demande de brevet FR 91 05279, intitulée "procédé de décodage d'un code convolutif à maximum de vraisemblance et pondération des décisions, et décodeur correspondant", déposée le 23.04.91 aux noms des mêmes déposants.

Ces décodeurs mettent notamment en oeuvre deux treillis distincts. La décision est prise, de façon classique, par remontée du chemin optimal dans le premier treillis. La pondération est déterminée ensuite, en continuant à remonter, dans le second treillis, le chemin optimal et son concurrent.

Selon le procédé de cette demande, les valeurs de pondération sont avantageusement soumises à une compression logarithmique. Toutefois, dans le cas du module décrit actuellement, il est apparu préférable que seul le premier décodeur 43 utilise cette loi de compression logarithmique. Elle est en quelque sorte reportée, dans le cas du second décodeur 48, ainsi qu'on le verra plus loin.

Les données $(X_3)_p$ produites par le second décodeur 48 alimentent une matrice 49 de désentrelacement de taille $n_E x n_E$ réalisant la fonction duale de l'entrelacement 47, et fournissant les données $(S)_p$ décodées.

Ces données $(S)_p$ décodées ne sont bien sûr prises en compte qu'en sortie du dernier module, qui présente le taux d'erreurs le plus faible, sauf dans le cas de tests, par exemple pour déterminer le nombre de modules nécessaires pour une application donnée.

Les données $(X_3)_p$ sont par ailleurs dirigées vers le bloc 50 d'estimation de la valeur $(X)_p$ en entrée. Ce bloc 50 tient également compte de la valeur correspondante $(X'_2)_p$, entrée du second décodeur 48, et mémorisé dans un registre à décalage 51, tenant lieu de ligne à retard. Ce registre 51, de longueur $L_2$, $L_2$ étant la latence du second décodeur 48, a pour but de compenser le temps de décodage de ce décodeur 48, de façon que le module 50 considère les données d'entrée $(X'_2)_p$ et de sortie $(X_3)_p$ du second décodeur à des instants homogènes.

Le rôle de ce bloc 50 d'estimation est donc de déterminer une estimation $(Z)_p$ du symbole émis X. Cette estimation est faite de façon que la grandeur $(Z)_p$ soit affectée d'un bruit additif décorrélé de celui affectant le symbole (X). $(Z)_p$ est prise en compte dans le module suivant (p+1). Ainsi, dans ce module (p+1), le premier décodeur traite un code virtuel, de rendement $R_1/(1+R_1)$, $R_1$ étant le rendement du premier codeur 11.

La décorrélation entre les bruits additifs de $(X)_p$ et $(Z)_p$ peut par exemple être assurée par une fonction g, qui ôte au résultat $(X_3)_p$ du second décodeur 48 la contribution liée à $(X)_p$. La fonction g est avantageusement la suivante :

$$g((X_2)_p, (X_3)_p) = (d_2 x (X_3)_p - (X_2)_p)/(d_2 - 1)$$

où $d_2$ est la distance libre du second code.

Le bloc 50 réalise ensuite avantageusement une compression logarithmique, précisément celle qui a été supprimée dans le second décodeur 48, des valeurs $g((X_2)_p, (X_3)_p)$. Les valeurs ainsi obtenues sont transmises à une matrice 52 de désentrelacement, identique à la matrice 49, et fournissant la sortie $(Z)_{p+1}$.

Le module de rang p assure par ailleurs la transmission des données reçues (X) et (Y), avec des retards permettant de présenter des sorties à des instants homogènes, pour le module suivant le rang p+1. Chaque module comprend donc deux registres à décalage 53 et 54, respectivement pour les données (X) et (Y). Ces registres à décalage tiennent lieu de lignes à retard, et ont une longueur de : $L_1 + L_2 + 2n_E^2$, de façon à compenser :

- la latence $L_1$ du premier décodeur 43 ;
- la latence $n_E^2$ de la matrice 47 d'entrelacement ;
- la latence $L_2$ du second décodeur 48 ;
- la latence $n_E^2$ de la matrice 52 de désentrelacement.

Les figures 5 et 6 présentent les résultats obtenus à l'aide d'un décodeur équipé de tels modules, pour un code de rendement 1/2 du type $3/5(\upsilon=4)//3/4(\upsilon=4)$, c'est-à-dire une concaténation parallèle de deux codes de rendements 3/5 et 3/4, à longueurs de contrainte $\upsilon=4$. L'abscisse des courbes est le rapport signal à bruit $E_b/N_0$ sur le canal de transmission ($E_b$ : énergie reçue par bit utile, $N_0$ : densité spectrale monolatérale de bruit). L'ordonnée est le taux d'erreurs binaires observé : les courbes présentent les résultats de décodage obtenus par simulation d'un canal gaussien, la démodulation étant cohérente.

La figure 5 correspond à un décodeur idéal, travaillant sur des variables réelles et avec un entrelacement de grande taille. La figure 6 présente le cas d'un décodeur "intégrable" sur circuit intégré, dont les caractéristiques principales sont les suivantes :

- échantillons codés sur 4 bits,
- longueur de treillis pour chaque décodeur : 58 dont 25 étages de révision pour la pondération,
- $\beta$ = 1.5,
- entrelacement à dispersion 31x31.

Les courbes $61_1$ à $61_5$ de la figure 5 et $71_1$ à $71_5$ de la figure 6 représentent respectivement les sorties $(S)_p$ d'une chaîne de cinq modules identiques. A titre de comparaison, on a également fait figurer les courbes 62 correspondant à une transmission non codée, et les courbes 63 et 64 correspondant aux courbes de correction des codes standards simples à longueurs de contrainte $\nu$=4 et $\nu$=6 respectivement.

Ces courbes permettent de tirer plusieurs conclusions. On constate tout d'abord qu'en présence d'un fort bruit de transmission, les résultats obtenus sont exceptionnellement meilleurs que ceux obtenus selon les techniques connues. Ainsi, par exemple, pour un taux d'erreur de $10^{-5}$, on constate que le gain est supérieur à 1,5dB, pour un décodeur à deux modules, et supérieur à 2,5dB, pour un décodeur à cinq modules, par rapport à un décodeur classique à longueur de contrainte $\nu$=6 (alors que les codeurs utilisés pour la simulation des performances de l'invention ont des longueurs de contrainte $\nu$=4).

Il apparaît également que les performances d'un décodeur de l'invention sont meilleures que celles des décodeurs connus, dès lors qu'on vise un taux d'erreurs de l'ordre de $10^{-4}$, même lorsque l'on utilise un seul module (courbes $61_1$ et $71_1$).

Enfin, on peut noter que chaque module rajouté permet d'améliorer la qualité du décodage, en s'approchant de la limite de Shannon, qui est 0 dB pour un code de rendement 1/2. A l'aide de cette série de courbes $61_1$ à $61_5$, il est possible de sélectionner, en fonction d'une application particulière, le nombre de modules nécessaires.

Les pertes de performances, à fort bruit, dans le cas "intégrable" (courbes $71_1$ à $71_5$) relativement au cas idéal (courbes $61_1$ à $61_5$), sont presque entièrement liées à la taille très réduite de la matrice d'entrelacement. On a en effet choisi des matrices de petite taille (31x31) de façon à limiter la surface de silicium utilisée. Avec de telles matrices, la surface de silicium occupée est de l'ordre de 30mm$^2$. L'expérience montre toutefois que des matrices plus grandes, de l'ordre de 100x100 (ce qui correspond à des mémoires RAM de tailles tout à fait classiques), permettent d'améliorer fortement les performances, tout en restant dans des limites tout à fait acceptables du point de vue de l'industrialisation d'un circuit intégré.

## Revendications

1. Procédé de décodage de données numériques $((X)_p, (Y_1)_p, (Y_2)_p)$ reçues sous une forme codées et correspondant à des données source,
caractérisé en ce qu'il comprend une procédure de décodage itérative comprenant :

    - une étape (43,48) de décodage d'une donnée intermédiaire $((X_1)_p)$ représentative d'une donnée reçue $((X)_p)$, produisant une donnée décodée $((X_3)_p)$, et
    - une étape d'estimation (50) de ladite donnée reçue $((X)_p)$, à l'aide de ladite donnée décodée $((X_3)_p)$, produisant une donnée estimée $((Z)_p)$,

    et en ce que ladite donnée intermédiaire $((X_1)_p)$ est obtenue en tenant compte (41) de ladite donnée reçue $((X)_p)$ avec, pour la première itération, une valeur prédéterminée, et pour les itérations suivantes, au moins une desdites données $((Z)_p)$ estimées lors des itérations précédentes.

2. Procédé selon la revendication 1, caractérisé en ce que ladite étape d'estimation affecte à ladite donnée estimée $((Z)_p)$ un bruit additif décorrélé du bruit affecté à ladite donnée reçue $((X)_p)$.

3. Procédé selon l'une quelconque des revendications 1 et 2, caractérisé en ce que ladite valeur prédéterminée est neutre, et en ce que lesdites combinaisons (41) sont, pour les itérations autre que la première, des sommations de ladite donnée reçue $((X)_p)$ et de la dernière donnée estimée $((Z)_p)$.

4. Procédé selon l'une quelconque des revendications 1 à 3, du type appliqué au décodage de données codées selon un procédé assurant la transmission conjointe des données source $((X)_p)$ et de données de redondance codées $((Y_1)_p, (Y_2)_p)$, caractérisé en ce que ladite étape de décodage prend en compte l'ensemble des données reçues, données source $((X)_p)$ et données codées $((Y_1)_p, (Y_2)_p)$, et en ce que ladite étape d'estimation est appliquée uniquement à l'estimation desdites données source $((X)_p)$.

EP 0 735 696 B1

5. Procédé selon l'une quelconque des revendications 1 à 4, caractérisé en ce que la ou lesdites étapes (43,48) de décodage mettent en oeuvre des algorithmes de décodage à maximum de vraisemblance, du type de l'algorithme de Viterbi, à décisions pondérées.

6. Procédé selon l'une quelconque des revendications 1 à 5, caractérisé en ce qu'il comprend une étape (42) de démultiplexage dirigeant les données codées reçues $((Y_1)_p, (Y_2)_p)$ vers lesdites étapes (43,48) de décodage adéquates et transmettant des valeurs nulles aux étapes (43,48) de décodage pour lesquelles aucune donnée codée n'a été transmise.

7. Procédé de codage et de décodage, dans lequel ledit codage met en oeuvre en parallèle au moins deux étapes (11,13) indépendantes de codage convolutif systématique, chacune desdites étapes (11,13) de codage prenant en compte l'ensemble desdites données source (d), et au moins une étape (12) d'entrelacement temporel desdites données source (d), modifiant l'ordre de prise en compte desdites données source (d) entre lesdites étapes (11,13) de codage,

et dans lequel ledit décodage est effectué selon le procédé de l'une quelconque des revendications 1 à 6.

8. Procédé selon la revendication 7, caractérisé en ce que ledit décodage comprend les étapes consécutives suivantes :

- détermination d'une donnée intermédiaire $((X_1)_p)$ obtenue par une combinaison d'une donnée reçue $((X)_p)$ avec, pour la première itération, une valeur prédéterminée, et pour les itérations suivantes, une donnée estimée $((Z)_p)$ lors des itérations précédentes,
- premier décodage (43) selon le premier codage convolutif, en fonction d'au moins une desdites données intermédiaires $((X_1)_p)$ et d'au moins une donnée codée $((Y_1)_p)$ produite par ladite première étape (11) de codage, produisant une première donnée décodée (45),
- entrelacement temporel (47) identique à ladite étape (12) d'entrelacement du procédé de codage desdites premières données décodées (45), produisant de premières données décodées $((X_2)_p)$,
- second décodage (48) selon le second codage convolutif, en fonction d'au moins une desdites premières données $((X_2)_p)$ décodées et désentrelacées et d'au moins une donnée $((Y_2)_p)$ codée produite par ladite seconde étape (13) de codage, produisant une seconde donnée $((X_3)_p)$ décodée,
- estimation (50) de la donnée source reçue $((X)_p)$, en fonction de l'une au moins desdites première et seconde données décodées $((X_2)_p, (X_3)_p)$, produisant une donnée estimée $((Z)_{p+1})$,
- désentrelacement (52) symétrique à ladite étape (47) d'entrelacement desdites données estimées $((Z)_{p+1})$.

9. Procédé selon la revendication 8, caractérisé en ce que ladite étape d'estimation (50) consiste à déterminer la grandeur $(d_2 x(X_1)-(X_2))/(d_2 - 1)$, où :

- $d_2$ est la distance libre dudit second codage redondant ;
- $(X_1)$ et $(X_2)$ sont les données décodées par lesdites première (43) et seconde (48) étapes de décodage.

10. Procédé selon l'une quelconque des revendications 8 à 9, caractérisé en ce que ladite étape (50) d'estimation est suivie, avant ladite étape (52) de désentrelacement, d'une étape de compression logarithmique.

11. Procédé selon l'une quelconque des revendications 8 à 10, caractérisé en ce que ladite première étape (43) de décodage est suivie d'une étape (44) de multiplication de ladite première donnée décodée (45) par un coefficient ß strictement supérieur à 1.

12. Procédé selon la revendication 11, caractérisé en ce que ledit coefficient ß est variable en fonction du rapport signal à bruit du canal de transmission.

13. Procédé selon l'une quelconque des revendications 8 à 12, caractérisé en ce que ladite première étape (43) de décodage est suivie d'une étape (411) de soustraction à ladite première donnée décodée (45) de ladite donnée estimée $((Z)_p)$.

14. Module de décodage, pour la réalisation d'une itération de la procédure de décodage du procédé de l'une quelconque des revendications 1 à 13, comprenant,

au moins deux entrées $((X)_p, (Y)_p, (Z)_p)$, correspondant à au moins une donnée reçue $((X)_p,(Y)_p)$ et à au moins une donnée estimée $((Z)_p)$,

au moins deux sorties $((Z)_{p+1}, (S)_p)$, correspondant à au moins une donnée décodée $((S)_p)$ et au moins une donnée estimée $((Z)_{p+1})$,

des moyens de production d'une donnée intermédiaire $((X_1)_p)$ à partir de ladite donnée reçue $((X)_p, (Y)_p)$ et de ladite donnée estimée $((Z)_p)$,

des moyens de formation d'une donnée décodée $((X_3)_p)$ à l'aide de ladite donnée intermédiaire $((X_1)_p)$, des moyens d'estimation de ladite donnée estimée $((Z)_{p+1})$ à partir de ladite donnée décodée $((X_3)_p)$ et de la donnée reçue $((X)_p,(Y)_p)$,

de sorte à être susceptible d'être cascadé avec au moins un autre module $(31_{p+1})$ identique.

15. Module selon la revendication 14, du type mettant en oeuvre le procédé de l'une quelconque des revendications 8 à 13, caractérisé en ce qu'il comprend :

- des moyens (41) de sommation des entrées correspondant à ladite donnée reçue $((X)_p)$ et à ladite donnée estimée $((Z)_p)$ ;
- des premiers moyens (43) de décodage de données codées $((X)_p, (Y_1)_p)$ selon un premier codage redondant, prenant en compte les données $((X_1)_p)$ issues desdits moyens (41) de sommation ;
- des premiers moyens (47) d'entrelacement des données issues desdits premiers moyens (43) de décodage ;
- des seconds moyens (48) de décodage de données codées $((X_2)_p, (Y_2)_p)$ selon un second codage redondant ;
- des moyens (50) d'estimation de ladite (ou desdites) donnée(s) reçue(s) $((X)_p)$ ;
- des moyens (52) de désentrelacement des données $((Z)_p)$ issues desdits moyens (50) d'estimation ;
- des moyens (49) de désentrelacement des données $((X_3)_p)$ issues desdits seconds moyens (48) de décodage, délivrant les données $((S)_p)$ décodées dans leur ordre d'origine ;
- des moyens (51,53,54) de retards destinés à compenser les latences des moyens (43,48) de décodage, des moyens (47) d'entrelacement et des moyens (49,52) de désentrelacement de façon que l'ensemble des données $((X)_p, (Z)_p, (S)_p, (Y)_p)$ issues dudit module correspondent à un même instant de réception.

16. Décodeur de données numériques, caractérisé en ce qu'il comprend au moins un module $(31_p)$ selon l'une quelconque des revendications 14 et 15.

## Claims

1. Process for decoding digital data $((X)_p, (Y_1)_p, (Y_2)_p)$ received in coded form and corresponding to source data, characterized in that it comprises an iterative decoding procedure comprising:

- a step (43, 48) of decoding an intermediate datum $((X_1)_p)$ representative of a datum received $((X)_p)$, producing a decoded datum $((X_1)_p)$ and
- a step (50) of estimating the said datum received $( (X) p)$ with the aid of the said decoded datum $((X_3)_p)$, producing an estimated datum $((Z)_p)$,

and in that the said intermediate datum $((X_1)_p)$ is obtained taking into account (41) the said datum received $((X)_p)$ with, for the first iteration, a predetermined value, and for the subsequent iterations, at least one of the said data $((Z)_p)$ estimated during the previous iterations.

2. Process according to Claim 1, characterized in that in the said estimating step additive noise decorrelated from the noise assigned to the said datum received $((X)_p)$ is assigned to the said estimated datum $((Z)_p)$.

3. Process according to either of Claims 1 and 2, characterized in that the said predetermined value is neutral, and in that the said combinations (41) are, for the iterations other than the first, summations of the said datum received $((X)_p)$ and of the last estimated datum $((Z)_p)$.

4. Process according to any one of Claims 1 to 3, of the type applied to the decoding of data coded according to a process effecting the joint transmission of the source data $((X)_p)$ and of coded redundancy data $((Y_1)_p, (Y_2)_p)$, characterized in that the said decoding step takes into account the set of data received, source data $((X)_p)$ and coded data $((Y_1)_p, (Y_2)_p)$, and in that the said estimating step is applied solely to the estimation of the said source data $((X)_p)$.

**5.** Process according to any one of Claims 1 to 4, characterized in that the said decoding step or steps (43, 48) implement maximum likelihood decoding algorithms of the Viterbi algorithm type with weighted decisions.

**6.** Process according to any one of Claims 1 to 5, characterized in that it comprises a demultiplexing step (42) directing the coded data received $((Y_1)_p, (Y_2)_p)$ towards the said appropriate decoding steps (43, 48) and transmitting zero values to the decoding steps (43, 48) for which values no coded datum has been transmitted.

**7.** Coding and decoding process, in which the said coding implements in parallel at least two independent steps (11, 13) of systematic convolutional coding. each of the said coding steps (11, 13) taking into account the set of the said source data (d), and at least one step (12) of temporal interleaving of the said source data (d), modifying the order in which the said source data (d) are taken into account between the said coding steps (11, 13), and in which the said decoding is performed according to the process of any one of Claims 1 to 6.

**8.** Process according to Claim 7, characterized in that the said decoding comprises the following consecutive steps:

- determination of an intermediate datum $((X_1)_p)$ obtained by a combination of a datum received $((X)_p)$ with, for the first iteration, a predetermined value, and for the subsequent dterations, a datum $((Z)_p)$ estimated during the previous iterations,
- first decoding (43) according to the first convolutional coding, as a function of at least one of the said intermediate data $((X_1)_p)$ and of at least one coded datum $((Y_1)_p)$ produced by the said first coding step (11), producing a first decoded datum (45),
- temporal interleaving (47) identical to the said interleaving step (12) of the process for coding the said first decoded data (45), producing first decoded data $((X_2)_p)$,
- second decoding (48) according to the second convolutional coding, as a function of at least one of the said first decoded and deinterleaved data $((X_2)_p)$ and of at least one coded datum $((Y_2)_p)$ produced by the said second coding step (13), producing a second decoded datum $((X_3)_p)$,
- estimation (50) of the source datum received $((X)_p)$, as a function of one at least of the said first and second decoded data $((X_2)_p, (X_3)_p)$, producing an estimated datum $((Z)_{p+1})$,
- deinterleaving (52) symmetric with the said step (47) of interleaving of the said estimated data $((Z)_{p+1})$.

**9.** Process according to Claim 8, characterized in that the said estimating step (50) consists in determining the quantity $(d_2 x(X_1) - (X_2)) / (d_2 - 1)$, where:

$d_2$ is the free distance of the said second redundant coding;
$(X_1)$ and $(X_2)$ are the data decoded by the said first (43) and second (48) decoding steps.

**10.** Process according to any one of Claims 8 to 9, characterized in that the said estimating step (50) is followed, before the said step (52) of deinterleaving, by a step of logarithmic compression.

**11.** Process according to any one of Claims 8 to 10, characterized in that the said first decoding step (43) is followed by a step (44) of multiplying the said first decoded datum (45) by a coefficient $\beta$ strictly greater than 1.

**12.** Process according to Claim 11, characterized in that the said coefficient $\beta$ can vary as a function of the signal-to-noise ratio of the transmission channel.

**13.** Process according to any one of Claims 8 to 12, characterized in that the said first decoding step (43) is followed by a step (411) of subtracting the said estimated datum $((Z)_p)$ from the said first decoded datum (45).

**14.** Decoding module for carrying out an iteration of the decoding procedure of the process of any one of Claims 1 to 13, comprising,

at least two inputs $((X)_p, (Y)_p, (Z)_p)$, corresponding to at least one datum received $((X)_p, (Y)_p)$ and to at least one estimated datum $((Z)p)$,
at least two outputs $((Z)_{p+1}, (S)_p)$, corresponding to at least one decoded datum $((S)_p)$ and at least one estimated datum $((Z)_{p+1})$,
means of producing an intermediate datum $((X_1)_p)$ from the said datum received $((X)_p, (Y)_p)$ and from the said estimated datum $((Z)_p)$,
means of forming a decoded datum $((X_a)_p)$ with the aid of the said intermediate datum $((X_1)_p)$, means of

estimating the said estimated datum $((Z)_{p+1})$ from the said decoded datum $((X_3)_p)$ and from the datum received $((X)_p, (Y)_p)$,
so as to be able to be cascaded with at least one other identical module $(31_{p+1})$.

**15.** Module according to Claim 14, of the type implementing the process of any one of Claims 8 to 13, characterized in that it comprises:

- means (41) of summation of the inputs corresponding to the said datum received $((X)_p)$ and to the said estimated datum $((Z)_p)$ ;
- first means (43) of decoding data $((X)_p, (Y_1)_p)$ coded according to a first redundant coding, taking into account the data $((X_1)_p)$ emanating from the said summation means (41);
- first means (47) of interleaving the data emanating from the said first decoding means (43);
- second means (48) of decoding data $((X_2)_p, (Y_2)_p)$ coded according to a second redundant coding;
- means (50) of estimating the said datum or data received $((X)_p)$ ;
- means (52) of deinterleaving the data $((Z)_p)$ emanating from the said estimating means (50);
- means (49) of deinterleaving the data $((X_3)_p)$ emanating from the said second decoding means (48), delivering the data $((S)_p)$ decoded in their original order;
- delay means (51, 53, 54) intended for compensating for the latencies of the decoding means (43, 48), of the interleaving means (47) and of the deinterleaving means (49, 52) in such a way that the set of data $((X)_p, (Z)_p, (S)_p, (Y)_p)$ emanating from the said module corresponds to one and the same instant of reception.

**16.** Decoder of digital data, characterized in that it comprises at least one module $(31_p)$ according to either of Claims 14 and 15.

**Patentansprüche**

**1.** Dekodierungsverfahren für digitale Daten $((X)_p, (Y_1)_p, (Y_2)_p)$, die in kodierter Form empfangen wurden und Quellendaten entsprechen,
dadurch gekennzeichnet, daß es ein iteratives Dekodierungsverfahren umfaßt, welches wiederum folgendes umfaßt:

- einen Dekodierschritt (43, 48) eines Zwischenwertes $((X_1)_p)$, weicher für einen empfangenen Datenwert $((X)_p)$ repräsentativ ist und einen dekodierten Datenwert $((X_3)_p)$ erzeugt und
- einen Schritt (50) zum Schätzen des empfangenen Datenwertes $((X)_p)$ mit Hilfe des dekodierten Datenwertes $((X_3)_p)$, der einen geschätzten Datenwert $((Z)_p)$ erzeugt,

und dadurch, daß man den Zwischenwert $((X_1)_p)_{\text{unter berüchsichtigung}}$ (41) des empfangenen Datenwertes $((X)_p)$ mit, für die erste Iteration, einem vorgegebenen Datenwert und, für die nachfolgenden Iterationen, mit mindestens einem der bei den vorhergehenden Iterationen geschätzten Datenwerten $((Z)_p)$ erhält.

**2.** Verfahren gemäß Anspruch 1,
dadurch gekennzeichnet, daß der Schritt zum Schätzen dem geschätzten Datenwert $((Z)_p)$ ein zusätzliches Rauschen zuordnet, das von dem Rauschen, welches von dem empfangenen Datenwert $((X)_p)$ herrührt, dekorreliert ist.

**3.** Verfahren gemäß einem der Ansprüche 1 oder 2,
dadurch gekennzeichnet, daß der vorgegebene Datenwert neutral ist und, daß es sich bei den Kombinationen (41) für alle Iterationen außer der ersten um Summen des ersten empfangenen Datenwertes $((X)_p)$ und des letzten geschätzten Datenwertes $((Z)_p)$ handelt.

**4.** Verfahren gemäß einem der Ansprüche 1 bis 3, von der Art, die auf das Dekodieren von Daten angewandt wird, die nach einem Verfahren kodiert wurden, welches das gemeinsame Senden der Quellendaten $((X)_p)$ und kodierter Redundanzdaten $((Y_1)_p, (Y_2)_p)$ sicherstellt,
dadurch gekennzeichnet, daß der Dekodierschritt die Gesamtheit der empfangenen Daten, der Quellendaten $((X)_p)$ und der kodierten Daten $((Y_1)_p, (Y_2)_p)$ berücksichtigt und, daß der Schritt zum Schätzen nur auf das Schätzen der Quellendaten $((X)_p)$ angewandt wird.

**5.** Verfahren gemäß einem der Ansprüche 1 bis 4,

dadurch gekennzeichnet, daß der oder die Dekodierschritt(e) (43, 48) Dekodieralgorithmen höchster Wahrscheinlichkeit, von der Art des Viterbi-Algorithmus mit gewichteter Entscheidung, einsetzen.

6. Verfahren gemäß einem der Ansprüche 1 bis 5,
dadurch gekennzeichnet, daß es einen Schritt (42) zum Demultiplexieren umfaßt, der die empfangenen kodierten Daten $((Y_1)_p, (Y_2)_p)$ zu den angemessenen Dekodierschritten (43, 48) leitet und Nullwerte an die Dekodierschritte (43, 48) überträgt, für die kein kodierter Datenwert übertragen wurde.

7. Kodier- und Dekodierverfahren, bei dem die Kodierung mindestens zwei unabhängige Schritte systematisch faltender Kodierung (11, 13) parallel anwendet, wobei jeder dieser Kodierschritte (11, 13) die Gesamtheit der Quelldaten (d) sowie mindestens einen Schritt (12) zur zeitlichen Verschachtelung der Quellendaten (d) berücksichtigt, wobei die Reihenfolge beim Berücksichtigen der Quellendaten (d) unter den Kodierschritten (11, 13) geändert wird, und wobei die Dekodierung nach dem Verfahren einem der Ansprüche 1 bis 6 erfolgt.

8. Verfahren gemäß Anspruch 7,
dadurch gekennzeichnet, daß die Dekodierung die unten angegebenen aufeinanderfolgenden Schritte umfaßt:

- Feststellen eines Zwischenwertes $((X_1)_p)$, den man durch Kombinieren eines empfangenen Datenwertes $((X)_p)$ mit, für die erste Iteration, einem vorgegebenen Datenwert und, für die nachfolgenden Iterationen, mit einem der bei den vorhergehenden Iterationen geschätzten Datenwerten $((Z)_p)$ erhält,
- ein erstes Dekodieren (43) gemäß der ersten faltenden Kodierung, als Funktion von mindestens einem der Zwischendatenwerte $((X_1)_p)$ und mindestens einem der beim ersten Kodierschritt (11) erzeugten kodierten Datenwerte $((Y_1)_p)$, wobei ein erster dekodierter Datenwert (45) erzeugt wird,
- eine zeitliche Verschachtelung (47), die dem Verschachtelungsschritt (12) des Kodierverfahrens der ersten dekodierten Daten (45) identisch ist, das erste dekodierte Daten $((X_2)_p)$ erzeugt,
- ein zweites Dekodieren (48) nach der zweiten faltenden Kodierung, als Funktion von mindestens einem der ersten dekodierten und entschachtelten Datenwerte $((X_2)_p)$ und von mindestens einem beim zweiten Kodierschritt (13) erzeugten kodierten Datenwert $((Y_2)_p)$, das einen zweiten dekodierten Datenwert $((X_3)_p)$ erzeugt,
- eine Schätzung (50) des empfangenen Quellendatenwertes $((X)_p)$ als Funktion von mindestens einer der ersten und zweiten dekodierten Datenwerte $((X_2)_p, (X_3)_p)$, die einen geschätzten Datenwert $((Z)_{p+1})$ erzeugt,
- eine zum Verschachtelungsschritt (47) der geschätzten Daten $((Z)_{p+1})$ symmetrische Entschachtelung (52).

9. Verfahren gemäß Anspruch 8,
dadurch gekennzeichnet, daß der Schritt zum Schätzen (50) darin besteht, die Größe $(d_2 \times (X_1) - (X_2)) / (d_2 - 1)$ festzustellen, wobei:

- $d_2$ die freie Entfernung von der zweiten redundanten Kodierung ist;
- $(X_1)$ und $(X_2)$ die von den ersten (43) und zweiten (48) Dekodierschritten dekodierten Daten sind.

10. Verfahren gemäß einem der Ansprüche 8 bis 9,
dadurch gekennzeichnet, daß auf den Schritt zum Schätzen (50) vor dem Entschachtelungsschritt (52) ein logarithmischer Kompressionsschritt folgt.

11. Verfahren gemäß einem der Ansprüche 8 bis 10,
dadurch gekennzeichnet, daß auf den ersten Dekodierschritt (42) ein Schritt (44) folgt, in dem der erste dekodierte Datenwert (45) mit einem Koeffizienten β multipliziert wird, der streng größer als 1 ist.

12. Verfahren gemäß Anspruch 11,
dadurch gekennzeichnet, daß der Koeffizient β als Funktion des Signal/Rausch-Verhältnisses des Übertragungskanals variiert.

13. Verfahren gemäß einem der Ansprüche 8 bis 12,
dadurch gekennzeichnet, daß auf den ersten Dekodierschritt (43) ein Schritt (411) folgt, bei dem der geschätzte Datenwert $((Z)_p)$ vom ersten dekodierten Wert (45) subtrahiert wird.

14. Dekodierungsmodul zum Durchführen einer Iteration des Dekodierungsvorgangs des Verfahrens gemäß einem der Ansprüche 1 bis 13, welches folgendes umfaßt:

- mindestens zwei Eingänge $((X)_p, (Y)_p, (Z)_p)$, die mindestens einem empfangenen Datenwert $((X)_p, (Y)_p)$ und mindestens einem geschätzten Datenwert $((Z)_p)$ entsprechen,
- mindestens zwei Ausgänge $((Z)_{p+1}, (S)_p)$, die mindestens einem dekodierten Datenwert $((S)_p)$ und mindestens einem geschätzten Datenwert $((Z)_{p+1})$ entsprechen,
- Mittel zum Erzeugen eines Zwischendatenwertes $((X_1)_p)$, ausgehend vom empfangenen Datenwert $((X)_p, (Y)_p)$ und des geschätzten Datenwertes $((Z)_p)$,
- Mittel zum Bilden eines dekodierten Datenwertes $((X_3)_p)$ mit Hilfe des Zwischendatenwertes $((X_1)_p)$,
- Mittel zum Schätzen des geschätzten Datenwertes $((Z)_{p+1})$, ausgehend vom dekodierten Datenwert $((X_3)_p)$ und dem empfangenen Datenwert $((X)_p, (Y)_p)$,

so daß es mit mindestens einem weiteren identischen Modul $(31_{p+1})$ in Kaskade geschaltet werden kann.

15. Modul gemäß Anspruch 14, von der Art, die das Verfahren gemäß einem der Ansprüche 8 bis 13 anwendet, dadurch gekennzeichnet, daß es folgendes umfaßt:

- Mittel (41) zum Addieren der dem empfangenen Datenwert $((X)_p)$ entsprechenden Eingangswerte zum geschätzten Datenwert $((Z)_p)$;
- erste Mittel (43) zum Dekodieren der nach einer ersten redundanten Kodierung kodierten Daten $((X)_p, (Y_1)_p)$, wobei die aus den Mitteln zum Addieren (41) stammenden Daten $((X_1)_p)$ berücksichtigt werden;
- erste Verschachtelungsmittel (47) für die aus den ersten Dekodierungsmittel (43) stammenden Daten;
- zweite Dekodierungsmittel (48) für die nach einer zweiten redundanten Kodierung kodierten Daten $((X_2)_p, (Y_2)_p)$;
- Mittel (50) zum Schätzen des (der) empfangenen Datenwertes (Datenwerte) $((X)_p)$;
- Entschachtelungsmittel (52) der aus den Schätzmitteln (50) stammenden Daten $((Z)_p)$;
- Entschachtelungsmittel (49) der aus den zweiten Dekodierungsmitteln (48) stammenden Daten $((X_3)_p)$, welche die dekodierten Daten $((S)_p)$ in ihrer ursprünglichen Reihenfolge liefern;
- Verzögerungsmittel (51, 53, 54), welche die Wartezeiten der Dekodierungsmittel (43, 48), der Verschachtelungsmittel (47) und der Entschachtelungsmittel (49, 52) ausgleichen sollen, so daß die Menge der aus dem Modul stammenden Daten $((X)_p, (Z)_p, (S)_p, (Y)_p)$ einem gleichen Empfangszeitpunkt entsprechen.

16. Dekodiervorrichtung für digitale Daten, dadurch gekennzeichnet, daß sie mindestens ein Modul $(31_p)$ nach einem der Ansprüche 14 oder 15 umfaßt.

Fig. 1

Fig. 2

Fig. 3

Fig. 4

EP 0 735 696 B1

Fig. 5

Fig. 6

Fig. 7